# EUROPÄISCHE PATENTSCHRIFT

(11) **EP 1 155 424 B1**
(45) Veröffentlichungstag und Bekanntmachung des Hinweises auf die Patenterteilung: **15.01.2003**
(21) Anmeldenummer: 00901461.4
(22) Anmeldetag: 05.02.2000
(51) Int. Cl.: H01G 9/20, H01L 31/048

(54) **PHOTOVOLTAISCHE ZELLE UND VERFAHREN ZU DEREN HERSTELLUNG**
PHOTOVOLTAIC CELL AND METHOD FOR THE PRODUCTION THEREOF
CELLULE PHOTOVOLTAIQUE ET PROCEDE DE FABRICATION DE LADITE CELLULE

(30) Priorität: 08.02.1999 CH 25299; 08.02.1999 CH 25399; 08.02.1999 CH 25499; 15.02.1999 CH 28199
(43) Veröffentlichungstag der Anmeldung: 21.11.2001
(73) Patentinhaber: Kurth Glas + Spiegel AG, 4528 Zuchwil (CH)
(72) Erfinder: KURTH, Martin, CH-4528 Zuchwil (CH)
(74) Vertreter: Spierenburg, Pieter
(86) Internationale Anmeldenummer: CH0000062
(87) Internationale Veröffentlichungsnummer: WO00048212

(56) Entgegenhaltungen:
- EP-A- 0 536 738
- WO-A-96/29715
- DE-A- 4 303 055
- DE-A- 19 528 401
- SUGIMURA R S ET AL: "ELECTRICAL ISOLATION DESIGN AND ELECTROCHEMICAL CORROSION IN THIN-FILM PHOTOVOLTAIC MODULES*" PHOTOVOLTAIC SPECIALISTS CONFERENCE,US,NEW YORK, IEEE, Bd. CONF. 20, 1988, Seiten 1103-1109, XP000167200

## Beschreibung

Die Erfindung betrifft eine photovoltaische Zelle nach dem Oberbegriff des Patentanspruchs 1, sowie ein Verfahren zu deren Herstellung nach dem Oberbegriff des Patentanspruchs 11.

Aus WO-A-93/18532 ist eine photoelektrochemische Zelle bekannt, die aus zwei dünnen leitfähigen Glasschichten besteht, an welchen jeweils transparente, dickere Isolierschichten sich anschliessen. Der Kern der Zelle wird durch eine als Elektrode dienende poröse Titandioxidschicht, eine Farbstoff- oder Dyeschicht und eine Elektrolytschicht gebildet. Zwischen der porösen Titandioxidschicht und der dünnen leitfähigen Glasschicht ist eine dünne Diffusionsschicht aus nichtporösem Titandioxid angeordnet. Die grundsätzliche Anordnung einer solchen photovoltaischen Zelle, die auch als Grätzel-Zelle in der Fachwelt bekanntgeworden ist, kann aus EP-B-0 525 070 entnommen werden, wo vor allem auf die Zusammensetzung der geeigneten Farbstoffe Bezug genommen wird.

Es gibt weitere Patentdokumente (z.B. DE-A-34 41 044 und EP-A-0 582 212), welche sich mit dem Auftragen der leitfähigen Schichten, insbesondere Metalloder Metalloxidschichten, auf dünne leitfähige Glasplatten beschäftigen. Zur Herstellung von Farbstoff-Solarzellen der obengenannten Art ist es femer aus EP-A-0 739 020 und EP-A-0 582 212 bekannt, Techniken einzusetzen, die den gewünschten Schichtenaufbau schrittweise in nacheinander erfolgenden Druckvorgängen ermöglichen. Zwischen den einzelnen Druckvorgängen kann gegebenenfalls eine thermische Aushärtung der jeweiligen Schicht erforderlich sein. Das gewünschte Resultat einer jeweils homogenen Schichtenfolge erfordert, wie diese bekannten Verfahren verdeutlichen, ein exaktes Einhalten der angegebenen Verfahrensparameter, wie beispielsweise Substratkonzentration, Temperatur, und Reaktionsdauer. Insbesondere sind bei einem schrittweisen Aufbau einer Farbstoffzelle die verschiedenen Materialien im Hinblick auf ihre Ausdehnungskoeffizienten aufeinander abzustimmen.

Obwohl von verschiedener Seite versucht worden ist, eine solche Grätzel-Zelle kommerziell einzusetzen, ist es bislang nicht oder kaum gelungen, eine photochemische Zelle der obengenannten Art von einer ausreichenden Grösse herzustellen. Ferner lässt auch der Wirkungsgrad dieser Zellen noch sehr zu wünschen übrig, was ebenfalls eine wirtschaftliche Verwendung bislang verhindert hat. Auch die Herstellkosten der bekannten Modulen liegen noch zu hoch, um eine wirtschaftliche Nutzung auf einer breiten Basis zu erreichen.

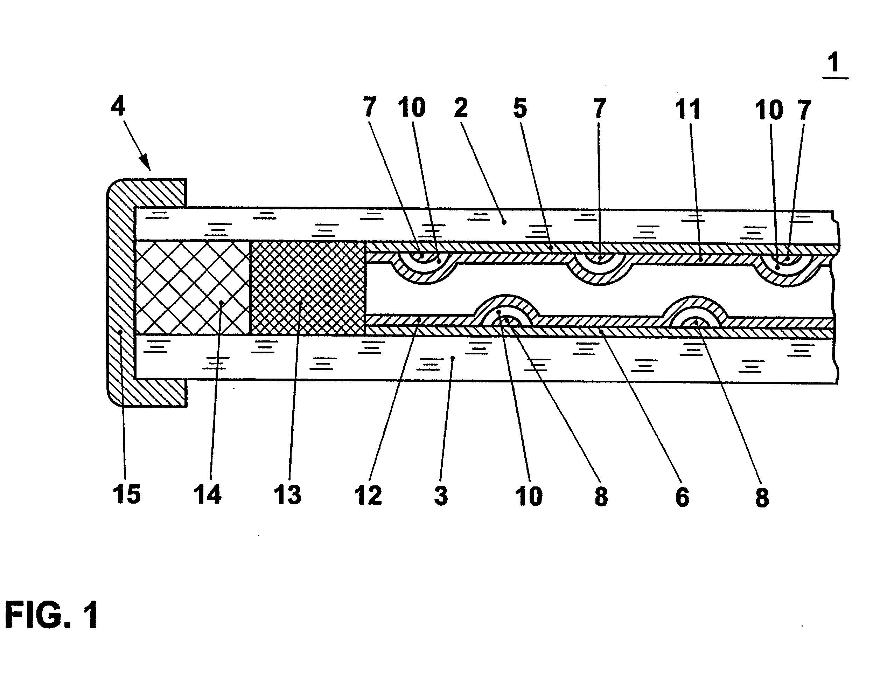

Ferner ist in DE-A-43 03 055 eine photovoltaische Zelle gezeigt, die sich aus zwei in einem Rahmen 21 gehaltenen Glasscheiben 1 zusammensetzt (siehe Fig. 8). Wie ersichtlich ist die untere Glasscheibe vom linken Teil und die obere Glasscheibe vom rechten Teil des Rahmens 21 gehalten. Der Zwischenraum zwischen den Glasscheiben 1 sind ringsum durch eine Dichtung 23, z.B. aus Silikonmasse, geschlossen. Wie in Figur 8 ersichtlich ist diese Dichtung 23 seitlich der einen Glasscheibe und aufliegend auf der gegenüberliegenden Glasscheibe angeordnet. Die Glasscheiben 1 sind in den verschiedenen Ausführungen in den Figuren 1 bis 6 dargestellt. Dabei sind beispielsweise in der Ausführung nach Figur 1 in der Glasscheibe 1 Nuten 2 eingefräst, eingeätzt oder dergleichen. Eine elektrisch leitende Beschichtung 3 aus Zinnoxid und etwa 0,2 bis 0,5 µm dick zieht sich auch durch die Nuten 2. Die Nuten 2 sind in zueinander rechtwinkligen Scharen angeordnet. In den Nuten 2 ist eine pastösen Masse einer Silberlegierung eingefüllt und durch Brennen bei 500 °C zu einem zusammenhängenden elektrischen Leiter gesintert worden. Somit sind in den Nuten 2 elektrische Leiterbahnen 4 eingelassen. Diese Leiterbahnen 4 sind noch in den Nuten 2 mit einer Abdeckung 5, z.B. aus Wasserglas oder aus Glaslot, überschichtet. Es ist klar, dass diese bekannte photovoltaische Zelle relativ aufwendig in der Herstellung ist. Auch die Dichtung der vorliegenden Zelle genügt kaum den Anforderungen, welche an eine als Grätzel-Zelle bekannte photovoltaische Zelle gestellt werden müssen.

Der vorliegenden Erfindung liegt nun die Aufgabe zugrunde, eine photovoltaische Zelle und ein Verfahren zu deren Herstellung anzugeben, dass die Kriterien für eine hohe Wirtschaftlichkeit und Zuverlässigkeit erfüllt.

Diese Aufgabe wird durch eine photovoltaische Zelle mit den Merkmalen des Patentanspruchs 1 und ein Herstellungsverfahren mit den Merkmalen des Patentanspruchs 11 gelöst.

Die erfindungsgemässe photovoltaische Zelle hat den grossen Vorteil, dass mit einem relativ einfachen Aufbau eine besonders effiziente Abdichtung der Zelle erreicht wird. Es hat sich besonders günstig erwiesen, wenn als Dichtungsmaterial Butylkautschuk oder dergleichen verwendet wird. Beim Herstellungsverfahren hat es sich besonders bewährt, wenn die Reinigung der Glasplatten sorgfältig in mehreren aufwendigen Reinigungsschritten vorgenommen wird, um eine optimale Haftung der elektrisch leitende Schichten auf dem Glassubstrat zu erreichen und um die Bildung von grösseren Blasen bei der Beschichtung des Glasüberzuges zu verhindern.

Weitere Vorteile der Erfindung folgen aus den abhängigen Patentansprüchen und aus der nachfolgenden Beschreibung, in welcher die Erfindung anhand eines in den schematischen Zeichnungen dargestellten Ausführungsbeispieles näher erläutert wird. Es zeigt:
- Fig. 1: einen Querschnitt durch eine photovoltaische Zelle,
- Fig. 2: eine Draufsicht auf eine erste Trägerplatte der Zelle der Figur 1,
- Fig. 3: eine Draufsicht auf eine zweite Trägerplatte,
- Fig. 4: den schematischen Verfahrensablauf zur Herstellung einer solchen photovoltaischen Zelle, und
- Fig. 5: eine Anordnung mehrerer solcher photovoltaischer Zellen zu einem Solarmodul.

In den Figuren sind für dieselben Elemente jeweils dieselben Bezugszeichen verwendet worden und erstmalige Erklärungen betreffen alle Figuren, wenn nicht ausdrücklich anders erwähnt.

In der Figur 1 ist Teil einer photovoltaischen Zelle 1 mit zwei beabstandeten Trägerplatten 2 und 3 im Querschnitt ersichtlich, die vom einem im Randbereich umlaufenden Dichtsystem 4 gehalten sind. Die Trägerplatten 2 und 3 sind aus einem vorgespannten Silikatglas, vorzugsweise Weissglas, hergestellt, wobei die einander zugewandten Flächen jeweils mit einer elektrisch leitenden Schicht 5 und 6 überzogen sind. Die Schichten 5 und 6 sind aus einem geeigneten Metall oder Metalloxid, hier SnO₂, ausgebildet. Auf diesen Schichten 5 und 6 sind jeweils eine Anordnung von parallelen Leiterbahnen 7 bzw. 8 vorgesehen, die vorzugsweise im wesentlichen aus Silber oder einer Silberlegierung hergestellt sind. Sie können jedoch auch aus Kupfer oder einer Kupferlegierung gebildet sein. Diese Leiterbahnen 7 und 8 sind jeweils mit einem isolierenden Überzug 10 versehen, der die Leiterbahnen 7 und 8 zum Zelleninnern hin elektrisch und gegen Korrosion isolieren. Der Überzug 10 besteht aus einem Glas frei von Schwermetallen, insbesondere mit einem geringen Anteil an Bismuth und/oder Zinn, das als Glasfluss über die Leiterbahnen 7 und 8 aufgebracht worden ist.

Über die mit dem Glasüberzug 10 isolierten Leiterbahnen 7 und 8 kann jeweils eine weitere elektrisch leitende Schicht 11 bzw. 12 aus Zinnoxid oder dergleichen aufgebracht sein, um eine noch höhere Ausbeute der photovoltaischen Zelle 1 zu erreichen. Das umlautende Dichtsystem 4 weist erste umlaufende Dichtung 13 aus einem Silikonkautschuk oder aus einem Heissleim oder "hot melt" mit dem Produktnamen "Bynel" auf, mit welcher die beiden Glasplatten 2 und 3 verbunden sind. Ausserhalb dieser ersten Dichtung 13 ist eine zweite umlaufende Dichtung 14 insbesondere aus Butylkautschuk vorgesehen. Die erste Dichtung 13 wirkt dabei als Wasserdampfbremse und die zweite Dichtung 14 als Wasserdampfsperre, so dass eine optimale Dichtung der photovoltaischen Zelle 1 erreicht wird. Im Randberelch der beiden Dichtungen 13 und 14 ist keine elektrisch leitende Schicht 5 und 6 vorgesehen, d.h. diese ist in diesem Bereich beispielsweise durch Sandstrahlen entfernt worden. Damit wird verhindert, dass ein Kurschluss zwischen den beiden Elektroden 5 und 6 über die Dichtungen 13 und/oder 14 entstehen kann. Bekanntlich ist ja Butylkautschuk in einem geringeren Mass elektrisch leitfähig. Über diese beiden Dichtungen 13 und 14 ist ferner eine Lötschicht 15 aus einem niederschmelzenden Lötzinn aufgebracht, damit auch äussere Wettereinflüsse nicht auf die photovoltaische Zelle 1 einwirken können. Der Abstand zwischen den beiden Trägerplatten 2 und 3 liegt im Bereich von etwa 50 µm bis 70 µm. Die Glasplatten 2 und 3 selber weisen eine Dicke von etwa 1,0 bis 3,5 mm auf, bevorzugt etwa 1,8 bis 2,2 mm.

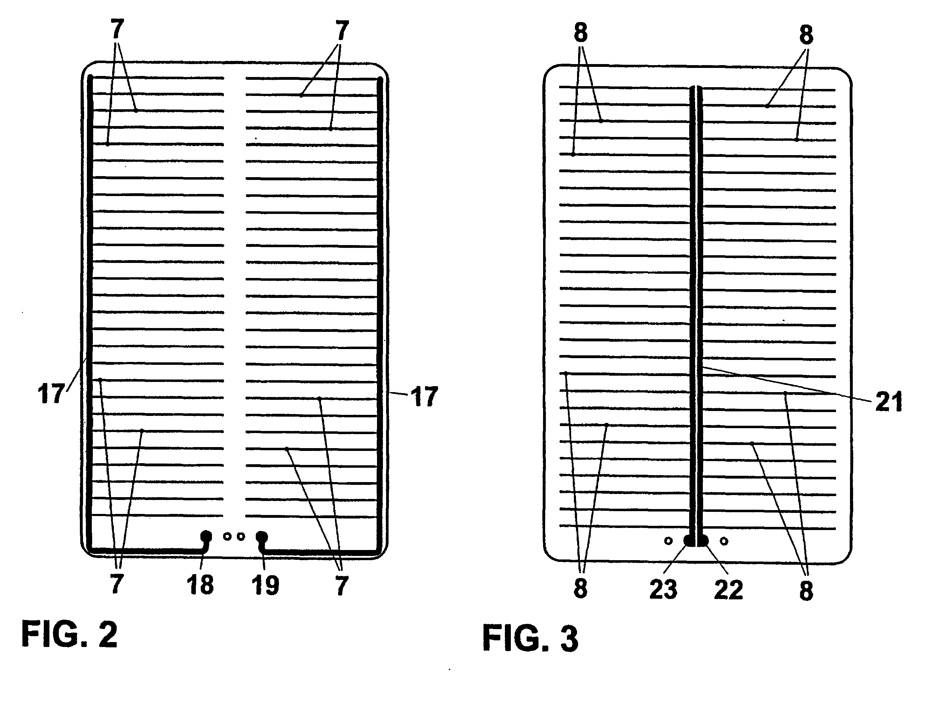

In Figur 2 ist nun der Verlauf der Leiterbahnen 7 auf der ersten Trägerplatte 2 ersichtlich. Die Leiterbahnen 7 sind dabei als einzelne Finger parallel zueinander angeordnet, die etwa in der Mitte der Träger- oder Glasplatte 2 enden. Diese Leiterbahnen 7 sind nun beidseitig im Randbereich 16 der Glasplatte 2 zu Sammelleiterbahnen 17 zusammengeführt, die am unteren Randbereich zu zwei Anschlusskontakten 18 und 19 führen. In Figur 3 ist der Verlauf der Leiterbahnen 8 der zweiten Träger- oder Glasplatte 3 ersichtlich, die ebenfalls als parallele Finger angeordnet sind, die im Randbereich enden und in der Mitte von zwei parallel angeordneten und senkrecht zu den Finger stehenden Sammelleiterbahnen 21 zu den Anschlusskontakten 22 und 23 geführt sind.

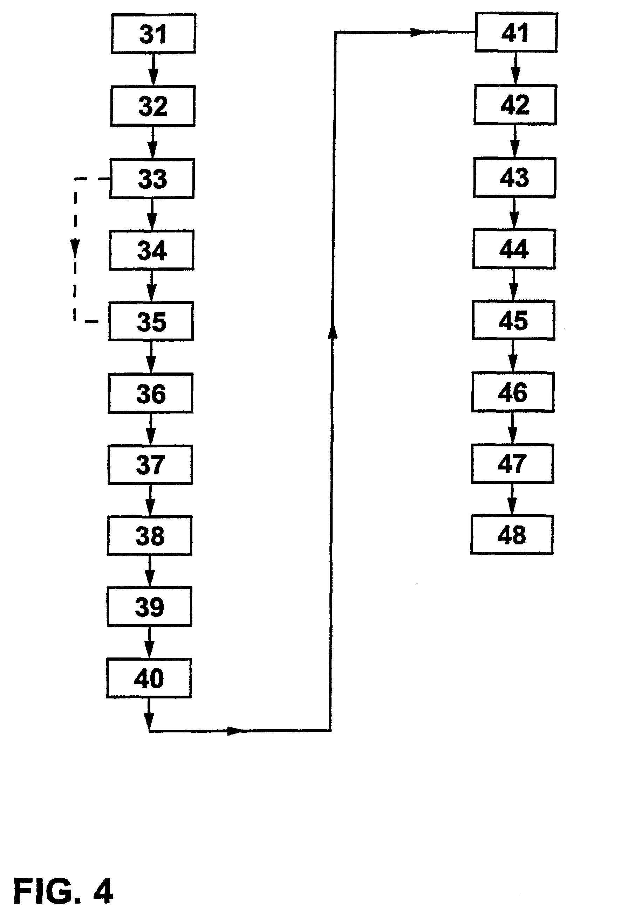

Die Herstellung eines erfindungsgemässen Moduls erfolgt nun gemäss des in Figur 4 dargestellten Ablaufs:

In einem ersten Schritt 31 werden aus grossen Glasplatten aus Silikatglas, insbesondere Weissglas, mit einer Gesamtdicke von 1.0 bis 3,5 mm, vorzugsweise etwa 1,8 bis 2,2 mm, die groben Aussenkonturen der Glasplatten 2 und 3 je nach gewünschten Grösse des Moduls zugeschnitten. Mit einem Wasserstrahl grossen Drucks werden sodann diese Glasplatten 2 und 3 auf ihre definitive Form zugeschnitten - Schritt 32. Mit der Wasserstrahltechnik und Diamant- und/oder Steinwerkzeuge können ferner Löcher, Flächenausschnitte, Rundecken, Rillen oder Profilkantenschliffe an den Glasplatten 2 und 3 entsprechend des jeweiligen Verwendungszweckes vorgesehen werden. Sodann werden die Glasplatten 2 und 3 in einem aufwendigen Reinigungsprozess 33, das unter anderem verschiedene Waschvorgänge mit einem 4%-igen Lösungsmittel in einer Ultraschallanlage umfasst, gereinigt, so dass keinerlei Fett- oder Lipidrückstände, oder Staubteilchen auf der Glasoberfläche mehr zurückbleiben. Ein solcher Reinigungsprozess ist an sich für den Herstellungsprozess von Flüssigkristallanzeigen ("LCD") bekannt.

Daraufhin werden die Glasplatten 2 und 3 vollflächig mit der leitfähigen Schicht 5 und 6 aus einem geeigneten Metalloxid wie SnO₂ in einem Sprühvorgang 34 gleichmässig aufgetragen. Der Flächenwiderstand der solchermassen aufgetragenen Schichten 5 und 6 soll dabei 15 Ohm/cm² nicht übersteigen und die Temperaturbeständigkeit im Bereich von 1000 °C liegen. Es können jedoch auch vorgefertigte Glasplatten mit einer elektrisch leitenden Beschichtung verwendet werden, die nach dem Zuschneiden - Schritt 32 - im Reinigungsprozess 33 gereinigt werden, wodurch Schritt 34 entfällt (gestrichelter Verlauf). Solche mit Zinnoxid beschichtete Glasplatten sind beispielsweise unter dem Namen TCO-Glas bei der Firma Asahi Glass Company Ltd., Tokyo, Japan erhältlich. Sodann werden in einem Siebdruckverfahren 35 die Leiterbahnen 7 und 8 in der Form einer elektrisch leitender Metallpaste, wie aus Silber oder Kupfer, regelmässig aufgetragen. Nachfolgend wird das Leiterbahnsystem in einem Trocknungsvorgang 36 bei Temperaturen von etwa 600 °C in einem Durchlaufofen getrocknet und auf der beschichteten Glasoberfläche eingebrannt und mit einem gekühlten Luftstrahl wieder abgekühlt - Schritt 37. Daraufhin werden die so beschichteten Glasplatten 2 und 3 in einem weiteren Reinigungsvorgang 38 mit einer entsprechenden Reinigungsflüssigkeit wieder gewaschen, so dass keinerlei Rückstände mehr auf der Oberfläche vorhanden sind. Die einzelnen Leitbahnen 7 und 8 werden sodann in einem weiteren Siebdruckvorgang 39 mit einem sehr dünnen Glasfluss überzogen. Dazu wird mit Vorteil schwermetallfreies Glas mit geringen Zusätzen an Bismuth und/oder Zinn verwendet. Dieser Überzug wird in einem Ofen mit einer Wärmestrahlung zunächst getrocknet und mit eine Strahlung im Bereich des nahen infrarots, d.h. im Bereich von 0,7 bis 1,5 µm, mit einer Temperatur von etwa 700 °C eingebrannt - Schritt 40. Um einen hermetischen Verschluss der Leiterbahnen 7 und 8 zu erreichen, werden die beiden obengenannten Vorgänge, d.h. Überziehen mit einem Glasfluss und anschliessende Trocknung, mehrere Male wiederholt. Die Schichtdicke des jeweiligen Glasüberzugs beträgt dann etwa 10 bis 25 µm. Die Gesamtdicke des definitiven Glasüberzugs 10 soll dabei im Bereich von 50 bis 70 µm liegen.

Durch diesen Schritt 40 werden die so beschichteten und vorbehandelten Glasplatten 2 und 3 während etwa 50 bis 80 Sekunden gleichzeitig thermisch vorgespannt und anschliessend im Abkühlvorgang 41 mit einem kalten Luftstrom schockartig abgekühlt. Bei diesem Vorspannprozess 41 werden die Glasplatten in einem Ofen mit unten liegenden Walzen aus einem keramischen Material und einer Vielzahl von Heizzonen mit aufsteigenden Temperaturen von etwa 550 °C bis 750 °C mit einer Oszillationsgeschwindigkeit von etwa 0,5 cm/Sek hin- und hergeführt, wodurch die Glaspiatten in einem dabei entstehenden Luftstrom leicht schwebend über die Walzen geführt werden. Die richtige Einstellung der Oberund Untertemperatur und die Oszillationsgeschwindigkeit der Walzen sind dabei derart auf einander abgestimmt, dass die sogenannten Bug- und Heckwellen in den Glasplatten weitestgehend verhindert werden, welche üblicherweise bei grösseren Glasplatten mit einer Dicke unter 2,5 mm entstehen würden. Damit wird erreicht, dass die Glasplatten 2 und 3 eine sehr hohe Planität erhalten und gleichzeitig Spannungen im Glas aufgebaut werden, was eine hohe Temperaturwechselbeständigkeit der Glasplatten 2 und 3 ergibt. Es wird somit auch eine höhere Festigkeit gegen Biege- und Zugspannungen im Glas erhalten, welche vor allem für die Anwendung bei photovoltaischen Zellen wie Farbstoff-Solarzellen und dergleichen sehr wichtig ist. Es kann ferner vorgesehen sein, die Glasplatten 2 und 3 wieder bei 500 °C während etwa einer Stunde zu entspannen, damit die fertige Zelle, welche dazu in mehreren Teilbereichen unterteilt worden ist, mittels Wasserstrahl oder dergleichen zu kleineren Einheiten zu zerschneiden.

Die derart behandelten Glasplatten 2 und 3 werden nun in den Randbereichen mit dem Dichtsystem 4 versehen, wobei in Schritt 42 die auf die Glasplatten 2 und 3 aufgebrachten, elektrisch leitenden Schichten 5, 11 bzw. 6, 12 durch Sandstrahlen oder dergleichen entfernt werden. Sodann wird im Schritt 43 die erste Dichtung 13 aus Silikonkautschuk in einer sehr dünnen Schicht auf die beiden Glasplatten 2 und 3 aufgetragen, so dass ein Abstand zwischen den Glasplatten 2 und 3 von etwa 50 µm bis 70 µm eingehalten werden kann. Im nächsten Schritt 44 wird eine zweite Dichtung 14 aus Butylkautschuk aufgebracht. In der Praxis werden die beiden Schritte 43 und 44 gleichzeitig durchgeführt. Anschliessend wird die ganze Umrandung der derart hergestellten photovoltaischen Zelle 1 mit Lötzinn vorzugsweise mit niedrigem Schmelzpunkt abgedichtet - Schritt 45.

Die derart hergestellte Zelle 1 wird nun im Füllvorgang 46 mit einem organischen Lösungsmittel als Elektrolyt, wie sie in EP-B-0 525 070 ausführlich beschrieben sind, über eine - hier nicht weiter dargestellte - Einfüllöffnung in einem der Glasplatten 2 oder 3 eingefüllt und anschliessend diese Öffnung mit einem geeigneten Klebstoff abgedichtet - Schritt 47. Als Einfüllöffnung kann eine Glasdurchführung oder Kapillare der Firma SCHOTT, D-Mainz durch den Glassteg 12 oder durch eine der Glasplatten 2 oder 3 dienen (vergl. Produktinformation Nr. 4830/1 d der Fa. SCHOTT). Damit ist die definitive photovoltaische Zelle oder Farbstoffzelle 1 vollständig fertiggestellt. Als letzte Schritt 48 wird sodann die fertige Zelle 1 auf ihre Dichtigkeit und auf ihre Funktionstauglichkeit geprüft, wozu die Zelle 1 beispielsweise während einer vorbestimmten Zeit in ein heissen Wasserbad eingetaucht und gleichzeitig die elektrische Funktion überprüft wird. Auch kann dazu die fertige Zelle 1 auf eine Temperatur von etwa 65 °C bis maximal 90 °C aufgeheizt werden. Es versteht sich, dass die so hergestellte Zelle 1 nicht nur für Elektrolyten des obengenannten Typs geeignet ist, sondern auch andere photovoltaische Substanzen eingefüllt werden können.

Die nach dem obigen Verfahren hergestellten Glasplatten können mit einem Energieaufwand von maximal 3 kWh pro Kilogramm gefertigt werden. Weil nunmehr keine besondere Überzüge verwendet werden, die nicht oder kaum entfernbar sind, können aus solchen Glasplatten bestehenden Module bei Verschleiss einfach wiederverwertet ("recycled") werden.

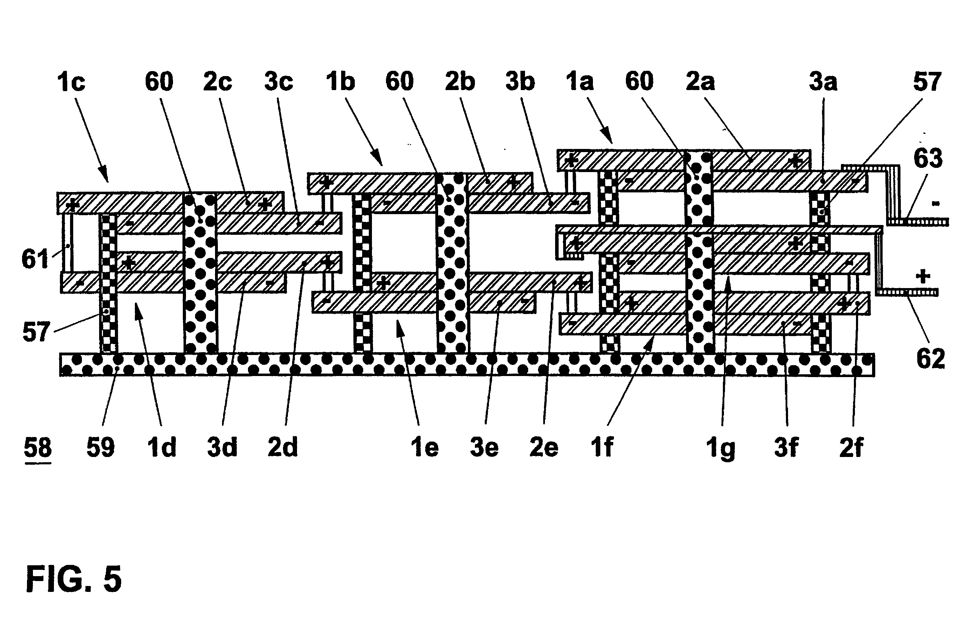

In Figur 5 ist des weiteren in einem Querschnitt eine Anordnung 54 von mehreren photovoltaischen Zellen 1a, 1b, 1c, 1d, 1e, 1f und 1g zu einem Solarmodul dargestellt, bei welchen die jeweilige obere Trägerplatte 2a bis 2c und 2g gegenüber der unteren Trägerplatte 3a bis 3c und 3g nach links vorsteht, bzw. die obere Trägerplatte 2d bis 2f gegenüber der unteren Trägerplatte 3d bis 3f nach rechts vorsteht. In Bereich dieses vorstehenden Teils 55 ist eine durchgehende Öffnung oder Bohrung (nicht-dargestellt) vorgesehen, durch welche eine Stützstange 57 - mit einem hier nicht weiter dargestellten Stützteller - hindurchgreift. Damit sind die einzelnen photovoltaischen Zellen 1a bis 1g einseitig wie die Blätter eines Baumastes aufgehängt. Seitlich zu den einzelnen Zellen 1a bis 1g ist eine Halterung 58 mit einer Bodenplatte 59 und Stützarmen 60 vorgesehen. Die Zellen 1a bis 1g sind mittels elektrischer Verbindungen 61 in Serie geschaltet und am in der Figur rechten Ende mit je einem positiven Kontaktanschluss 62 und einem negativen Kontaktanschluss 63 versehen. Diese ganze Anordnung 54 kann nun ohne weiteres in einem Solarmodul eingebaut sein, wie es ausführlich in der Internationalen Patentanmeldung PC17CH 00/00054 vom 1. Februar 2000 derselben Anmelderin beschrieben worden ist und auf deren Inhalt hier ausdrücklich hingewiesen wird. Insbesondere können zwischen den dort beschriebenen Glassubstraten 2 und 3 noch weitere Stützsprossen vorgesehen sein, um ein Durchbiegen der Glassubstraten zu verhindern, wenn die Aussenmassen ein gewisses Mass überschreiten.

## Patentansprüche

1. Photovoltaische Zelle (1), insbesondere Farbstoff- oder Solarzelle, mit aus Glas ausgebildeten Trägerplatten (2, 3), die je mit einer elektrisch leitenden Schicht (5, 6) überzogen sind, und Leiterbahnen (7, 8) auf den elektrisch leitenden Schichten (5, 6), die zum Zelleninnern von einem isolierenden Überzug (10) versehen sind, wobei die auf einem Abstand parallel zueinander angeordneten Trägerplatten in den Randbereichen mit einer umlaufenden Abdichtung versehen sind, **dadurch gekennzeichnet, dass** die Leiterbahnen (7, 8) parallel zueinander auf die plane Fläche der Trägerplatten (2, 3) angeordnet und der jeweilige isolierende Überzug (10) auf den von der Trägerplatte vorstehenden Leiterbahnen (7, 8) aufgetragen sind, und die Abdichtung (13, 14) zwischen den beiden Trägerplatten (2, 3) angeordnet ist.

2. Photovoltaische Zelle nach Anspruch 1, **dadurch gekennzeichnet, dass** die Leiterbahnen (7) im Wesentlichen aus Silber, einer Silberlegierung, Kupfer oder einer Kupferlegierung bestehen.

3. Photovoltaische Zelle nach Anspruch 1 oder 2, **dadurch gekennzeichnet, dass** der isolierende Überzug (10) im Wesentlichen aus einem nicht-schwermetallhaltigen, insbesondere Bismuth und/oder Zinn aufweisenden Glasüberzug besteht.

4. Photovoltaische Zelle nach Anspruch 1 bis 3, **dadurch gekennzeichnet, dass** über den isolierenden Überzug (10) eine weitere elektrisch leitende Schicht (11, 12) vorgesehen ist.

5. Photovoltaische Zelle nach einem der Ansprüche 1 bis 4 , **dadurch gekennzeichnet, dass** die Abdichtung aus einer ersten, wasserdampfbremsenden Dichtung (13), insbesondere aus Silikonkautschuk, besteht.

6. Photovoltaische Zelle nach Anspruch 5, **dadurch gekennzeichnet, dass** die Dichtung (13) aus einem Heissleim besteht.

7. Photovoltaische Zelle nach Anspruch 5 oder 6, **dadurch gekennzeichnet, dass** eine zweite, wasserdampfsperrende Dichtung (14), insbesondere aus Butylkautschuk, auf der ersten Dichtung (13) vorgesehen ist.

8. Photovoltaische Zelle nach einem der Ansprüche 1 bis 7, **dadurch gekennzeichnet, dass** die Glasplatten (2, 3) eine Dicke von höchstens 3,5 mm, insbesondere im Bereich von 1,8 bis 2,2 mm, aufweisen.

9. Photovoltaische Zelle nach Anspruch 8, **dadurch gekennzeichnet, dass** die Glasplatten (2, 3) aus Silikatglas, insbesondere aus Weissglas, hergestellt sind.

10. Photovoltaische Zelle nach einem der Ansprüche 1 bis 9, **dadurch gekennzeichnet, dass** die elektrisch leitenden Schichten (5, 6) aus Zinndioxid bestehen.

11. Verfahren zur Herstellung einer photovoltaischen Zelle (1) mit elektrisch leitend beschichteten aus Glas ausgebildeten Trägerplatten (2, 3), welche in den Randbereichen mit einer umlaufenden Abdichtung versehen werden, **dadurch gekennzeichnet, dass** die beschichteten Trägerplatten (2, 3) in einem Waschvorgang gereinigt werden, anschliessend im Wesentlichen parallel angeordnete elektrische Leiterbahnen (7, 8) mittels eines Siebdruckprozesses auf die planen Flächen der Trägerplatten (2, 3) aufgetragen und bei einer Temperatur von über 500 °C, insbesondere etwa 600 °C, getrocknet und eingebrannt werden, die Leiterbahnen (7, 8) nach einem weiteren Reinigungsvorgang mit einem isolierenden Überzug (10) überzogen werden und zwischen den Trägerplatten (7, 8) eine umlaufende Abdichtung (13, 14) angebracht wird.

12. Verfahren nach Anspruch 11, **dadurch gekennzeichnet, dass** als Überzug (10) ein Glasfluss aus einem schwermetallfreien Glas aufgetragen und anschliessend in einem Ofen mit naher Infrarotstrahlung gehärtet wird.

13. Verfahren nach Anspruch 12, **dadurch gekennzeichnet, dass** mehrere Schichten aus dem Glasfluss hintereinander aufgebracht werden.

14. Verfahren nach einem der Ansprüche 11 bis 13, **dadurch gekennzeichnet, dass** eine weitere elektrisch leitende Schicht (11, 12) auf den mit einem isolierenden Überzug (10) versehenen Leiterbahnen (7, 8) aufgebracht wird.

15. Verfahren nach einem der Anspruche 11 bis 14, **dadurch gekennzeichnet, dass** die Trägerplatten (2, 3) anschliessend in einem thermischen Vorspannprozess in einem Ofen auf eine Temperatur über 600 °C aufgeheizt und dann schockartig abgekühlt werden.

16. Verfahren nach Anspruch 15, **dadurch gekennzeichnet, dass** die Trägerplatten (2, 3) in einem Ofen mit mehreren Heizzonen stufenweise steigender Temperatur mit einer vorbestimmten Oszillationsgeschwindigkeit während einer vorgegebenen Zeitspanne hin- und herbewegt werden.

17. Verfahren nach einem der Ansprüche 11 bis 16, **dadurch gekennzeichnet, dass** eine erste, wasserdampfbremsende Dichtung (13), vorzugsweise aus Silikonkautschuk, im Randbereich zwischen den beiden Trägerplatten (2, 3) angebracht wird.

18. Verfahren nach Anspruch 17, **dadurch gekennzeichnet, dass** eine zweite, wasserdampfsperrende Dichtung (14), vorzugsweise aus Butylkautschuk, auf der ersten Dichtung (13) angebracht wird.

## Claims

1. Photovoltaic cell (1), in particular a dye or solar cell, with support panes (2, 3) formed of glass, each of which is coated with an electrically conductive layer, and conductor leads (7, 8) arranged on top of the electrically conductive layers (5,6), which are provided by an insulating coating (10) towards the cell interior, whereas the support panes, being arranged parallel and at a distance to each other, are provided at the border zones with a circumferentially surrounding seal, **characterized in that** the conductor leads (7, 8) are arranged parallel to each other on the flat plane of the support panes (2, 3) and the successive insulating coating (10) is applied on the conductor leads (7, 8) protruding from the support pane, and the seal (13, 14) is arranged between both support panes (2,3).

2. Photovoltaic cell according to the claim 1, **characterized in that** the conductor leads (7) substantially comprises silver, a silver alloy, copper or a copper alloy.

3. Photovoltaic cell according to the claim 1 or 2, **characterized in that** the insulating coating (10) is substantially free of heavy metals, and in particular comprises bismuth and/or tin.

4. Photovoltaic cell according to one of the claims 1 to 3, **characterized in that** on top of the insulating coating (10) a further electrically conductive layer (11, 12) is provided.

5. Photovoltaic cell according to one of the claims 1 to 4, **characterized in that** the seal comprises a first, vapour refraining seal, in particular made from silicon rubber.

6. Photovoltaic cell according to the claim 5, **characterized in that** the seal (13) comprise a hot melt adhesive.

7. Photovoltaic cell according to claim 5 or 6, **characterized in that** a second, vapour blocking barrier seal (14), especially made from butyl rubber, is applied on the first seal.

8. Photovoltaic cell according to one of claims 1 to 7, **characterized in that** the glass panes (2, 3) have a thickness of a not more than 3.5 mm, in particular in the range from 1.8 to 2.2 mm.

9. Photovoltaic cell according to the claim 8, **characterized in that** the glass panes (2, 3) are made of silicate glass, in particular of colourless (white) glass.

10. Photovoltaic cell according to one of the claims 1 to 9, **characterized in that** the electrically conductive layers (5, 6) comprise tin dioxide.

11. Method of manufacturing a photovoltaic cell (1) having an electrically conducting coating on glass support panes (2, 3) which are provided a circumferentially extending seal at the border zones, **characterized in that** the coated support panes (2, 3) are cleaned in a cleaning process, thereafter essentially parallel conductor leads (7, 8) are applied by a screen printing process on the plane surfaces of the support panes (2, 3), and are dried and baked at a temperature exceeding 500 °C, in particular at about 600 °C, and after a further cleaning process, the conductor leads (7. 8) are coated with an insulating coating (10) and a surrounding seal (13, 14) is applied between the support panes (7, 8).

12. Method according to claim 11, **characterized in that** as a coating (10) a glass flow free of heavy metals is applied and subsequently is cured in a kiln using near infrared radiation.

13. Method according to claim 12, **characterized in that** a plurality of layers of the glass flow are applied consecutively.

14. Method according to one of claims 11 to 13, **characterized in that** a further electrically conductive layer (11, 12) is applied to the conductor leads (7, 8) which are provided with an insulating coating (10).

15. Method according to one of claims 11 to 14, **characterized in that** subsequently the support panes (2, 3) are heated in a thermal pre-stressing process in a kiln to a temperature higher than 600°C and then are shock-chilled.

16. Method according to the claim 15, **characterized in that** the support panes (2, 3) are moved to and fro in a kiln subdivided into a plurality of heating zones, the temperatures in which increase step by step, at a predetermined oscillating speed over a predetermined time period.

17. Method according to one of claims 11 to 16, **characterized in that** a first, vapour refraining seal (13), preferentially made from silicon rubber, is applied in the border zone between the two support panes (2, 3).

18. Method according to the claim 17, **characterized in that** a second, vapour blocking barrier seal (14), preferentially made from butyl rubber, is applied on the first seal (13).

## Revendications

1. Cellule photovoltaïque (1), en particulier cellule à colorants ou solaire, comprenant des plaques supports (2, 3) en verre, recouvertes chacune d'une couche conduisant l'électricité (5, 6), et des réseaux de circuits imprimés (7,8) sur les couches conduisant l'électricité (5, 6), qui sont munis vers l'intérieur de la cellule d'un revêtement isolant (10), les plaques supports disposées parallèlement entre elles à une certaine distance l'une de l'autre étant munies, dans les zones de bordure, d'une étanchéité périphérique, **caractérisée en ce que** les réseaux de circuits imprimés (7, 8) sont disposés parallèlement entre eux sur la surface plane des plaques supports (2, 3), le revêtement isolant (10) est appliqué sur chacun des réseaux de circuits imprimés (7, 8) faisant saillie de la plaque support et l'étanchéité (13, 14) est disposée entre les deux plaques supports (2, 3).

2. Cellule photovoltaïque selon la revendication 1, **caractérisée en ce que** les réseaux de circuits imprimés (7) sont constitués essentiellement d'argent, d'un alliage d'argent, de cuivre ou d'un alliage de cuivre.

3. Cellule photovoltaïque selon la revendication 1 ou 2, **caractérisée en ce que** le revêtement isolant (10) est constitué essentiellement d'un revêtement en verre ne contenant pas de métal lourd, en particulier présentant du bismuth et/ou du zinc.

4. Cellule photovoltaïque selon les revendications 1 à 3, **caractérisée en ce qu'**une autre couche conduisant l'électricité (11, 12) est prévue sur le revêtement isolant (10).

5. Cellule photovoltaïque selon l'une des revendications 1 à 4, **caractérisée en ce que** l'étanchéité est constituée d'un premier joint (13) formant barrière contre la vapeur d'eau, en particulier en caoutchouc silicone.

6. Cellule photovoltaïque selon la revendication 5, **caractérisée en ce que** le joint (13) est réalisé dans une colle thermodurcissable.

7. Cellule photovoltaïque selon la revendication 5 ou 6, **caractérisé en ce qu'**un deuxième joint (14) formant barrière contre la vapeur d'eau, en particulier en caoutchouc butyle, est prévu sur le premier joint (13).

8. Cellule photovoltaïque selon l'une des revendications 1 à 7, **caractérisée en ce que** les plaques en verre (2, 3) présentent une épaisseur maximale de 3,5 mm, en particulier dans la plage de 1,8 à 2,2 mm.

9. Cellule photovoltaïque selon la revendication 8, **caractérisée en ce que** les plaques de verre (2, 3) sont réalisées en verre aux silicates, en particulier en verre blanc.

10. Cellule photovoltaïque selon l'une des revendications 1 à 9, **caractérisée en ce que** les couches conduisant l'électricité (5, 6) sont réalisées en oxyde stannique.

11. Procédé pour la fabrication d'une cellule photovoltaïque (1) avec des plaques supports (2, 3) réalisées en verre, recouvertes de couches conduisant l'électricité, qui sont munies dans les zones de bordure d'une étanchéité périphérique, **caractérisée en ce que** les plaques supports (2, 3) recouvertes des couches sont nettoyées au cours d'une opération de lavage, des réseaux de circuits imprimés électriques (7, 8), disposés essentiellement parallèlement, sont ensuite appliqués au moyen d'un processus de sérigraphie sur les surfaces planes des plaques supports (2, 3) et séchés et cuits à une température de plus de 500°C, en particulier d'environ 600°C, les réseaux de circuits imprimés (7, 8) sont revêtus d'un revêtement isolant (10) après une autre opération de nettoyage et une étanchéité périphérique (13, 14) est appliquée entre les plaques supports (7, 8).

12. Procédé selon la revendication 11, **caractérisé en ce que**, comme revêtement (10), un flux de verre exempt de métal lourd est appliqué puis trempé dans un four avec un rayonnement infrarouge proche.

13. Procédé selon la revendication 12, **caractérisé en ce que** plusieurs couches de flux de verre sont appliquées successivement.

14. Procédé selon l'une des revendications 11 à 13, **caractérisé en ce qu'**une autre couche conduisant l'électricité (11, 12) est appliquée sur les réseaux de circuits imprimés (7, 8) munis d'un revêtement isolant (10).

15. Procédé selon l'une des revendications 11 à 14, **caractérisé en ce que** les plaques supports (2, 3) sont ensuite chauffées au cours d'un processus de trempe thermique dans un four à une température de plus de 600°C et ensuite refroidies brusquement.

16. Procédé selon la revendication 15, **caractérisé en ce que** les plaques support (2, 3) sont déplacées en va et vient dans un four avec plusieurs zones de chauffe de température augmentant graduellement, avec une vitesse d'oscillation prédéterminée pendant un laps de temps prédéfini.

17. Procédé selon l'une des revendications 11 à 16, **caractérisé en ce qu'**un premier joint (13) formant barrière contre la vapeur d'eau, de préférence en caoutchouc silicone, est disposé dans la zone de bordure entre les deux plaques support (2, 3).

18. Procédé selon la revendication 17, **caractérisé en ce qu'**un deuxième joint formant barrière contre la vapeur d'eau (14), de préférence en caoutchouc butyle, est disposé sur le premier joint (13).
